# EUROPEAN PATENT APPLICATION

(11) **EP 4 524 801 A1**
(43) Date of publication of application: **19.03.2025**
(21) Application number: 24200402.6
(22) Date of filing: 13.09.2024
(51) Int. Cl.: G06F 30/00, G06T 17/20, G06T 19/20

(54) **EDGE HIGHLIGHTING FOR LIGHTWEIGHT VIEWER**

(30) Priority: 15.09.2023 US 202318467866
(71) Applicant: RTX Corporation, Farmington, CT 06032 (US)
(72) Inventor: DOLL, Stephen, Farmington, 06032 (US)
(74) Representative: Dehns

(57) **Abstract**

A user interface for a lightweight viewer may include, among other things, a viewing window operable to display geometry established by one or more geometric objects of a tessellated model. The one or more geometric objects are associated with respective edges of the geometry. One or more annotation objects of the tessellated model are assigned information associated with the respective edges and are operable to depict the respective information as a graphical annotation in the viewing window. One or more curve objects of the tessellated model are associated with the respective one or more annotation objects and include respective curves dimensioned to follow the respective edges of the geometry. The one or more curve objects are operable to selectively depict the respective edges of the geometry in the viewing window in response to selection of the respective annotation object. A method of establishing a tessellated model is also disclosed.

## Description

### BACKGROUND

This disclosure relates to modeling and interaction with the design of various components.

Computer-Aided Design (CAD) systems are known and may be utilized to generate two-dimensional and three-dimensional (3D) models of various components. The associated CAD files may be relatively large, which may impede transfer to other computing systems. A lightweight, tessellated representation of the CAD model may be generated and stored within a file that excludes the original CAD model. The file may be saved in a Portable Document Format (PDF) or another file format. A lightweight viewer may be utilized to view the lightweight representation.

### SUMMARY

A user interface for a lightweight viewer according to a first aspect of the invention includes a viewing window operable to display geometry established by one or more geometric objects of a tessellated model. The one or more geometric objects are associated with respective edges of the geometry. One or more annotation objects of the tessellated model are assigned information associated with the respective edges. The one or more annotation objects are operable to depict the respective information as a graphical annotation in the viewing window. One or more curve objects of the tessellated model are associated with the respective one or more annotation objects and include respective curves dimensioned to follow the respective edges of the geometry. The one or more curve objects are operable to selectively depict the respective edges of the geometry in the viewing window in response to selection of the respective annotation object.

Optionally, the one or more curve objects are operable to visually enhance respective segments of the one or more geometric objects associated with the respective edges.

Optionally, selection of the one or more annotation objects causes the viewing window to highlight a boundary of the respective one or more geometric objects.

Optionally, the one or more geometric objects are operable to depict the boundary by a set of triangles established by tessellation of the geometry.

Optionally, the one or more curve objects are selectively activated by selection of the respective one or more annotations but not by selection any of the one or more geometric objects in the viewing window.

Optionally, each of the one or more curve objects is operable to depict the respective curve as a straight line, an arc, or a complex curve in the viewing window.

Optionally, the tessellated model excludes any CAD model that establishes the geometry.

A system for generating a tessellated model according to a second aspect of the invention includes a computing device including one or more processors coupled to memory. The computing device is operable to execute a modelling environment. The modeling environment is operable to access a computer-aided design (CAD) model associated with geometry, generate one or more geometric objects that establish a tessellation of the geometry in the CAD model, generate one or more annotation objects assigned information associated with the respective one or more geometric objects, extract edges of the geometry in the CAD model as a set of curves that differ from the tessellation of the geometry, generating one or more curve objects, assign and the set of curves to the respective one or more curve objects. The one or more curve objects are associated with the respective one or more annotation objects. The modeling environment is operable to generate a tessellated model including the one or more geometric objects. The one or more annotation objects and the one or more curve objects are operable to display the tessellation of the geometry in a viewing window of a user interface. The one or more annotation objects are operable to depict the respective information as a graphical annotation in the viewing window. The one or more curve objects are operable to selectively depict the respective edges of the geometry in the viewing window in response to selection of the respective annotation object.

Optionally, the one or more curve objects are operable to visually enhance a boundary of the respective geometry.

Optionally, the one or more geometric objects are operable to depict the boundary by one or more triangles established by the tessellation of the geometry.

Optionally, the one or more curve objects are selectively activated in response to selection of the respective one or more annotation objects but not in response to selection any of the one or more geometric objects in the viewing window.

Optionally, the one or more annotation objects include a plurality of annotation objects. The one or more curve objects may include a plurality of curve objects associated with the respective annotation objects. Each of the curve objects may be operable to deactivate a remainder of the curve objects in response to selection of the respective annotation object.

Optionally, each of the one or more curve objects is operable to depict the respective curve as a straight line, an arc, or a complex curve in the viewing window.

Optionally, the modeling environment is operable to store the tessellated model in a file readable by a lightweight viewer.

Optionally, the file excludes the CAD model.

Optionally, the modeling environment is operable to store code in the file that is operable to cause one or more functions associated with the tessellated model to execute in the lightweight viewer.

A method of establishing a tessellated model according to a third aspect of the invention includes generating one or more geometric objects that establish a tessellation of geometry stored in a computer-aided design (CAD) model. The one or more geometric objects are operable to display the tessellation of the geometry in a viewing window of a user interface. The method includes generating one or more annotation objects and assigning information associated with the respective one or more geometric objects to the one or more annotation objects. The one or more annotation objects are operable to depict the respective information as a graphical annotation in the viewing window. The method includes extracting edges of the geometry in the CAD model as a set of curves that differ from the tessellation of the geometry, generating one or more curve objects, assigning the set of curves to the respective one or more curve objects, and linking the one or more annotation objects to one or more of the curve objects. The one or more curve objects are operable to selectively depict the respective edges of the geometry in the viewing window in response to selection of the respective annotation object. The method includes generating a tessellated model including the one or more geometric objects. The one or more annotation objects and the one or more curve objects.

Optionally, the one or more curve objects are operable to visually enhance respective segments of the one or more geometric objects associated with the respective edges.

Optionally, selection of the one or more annotation objects causes the viewing window to highlight a boundary of the respective one or more geometric objects. The one or more geometric objects may be operable to depict the boundary by a set of triangles established by the tessellation of the geometry.

Optionally, the method includes storing the tessellated model in at least one file that excludes the CAD model.

Optionally, the method includes displaying the tessellated model in a lightweight viewer.

The present disclosure may include any one or more of the individual features disclosed above and/or below alone or in any combination thereof.

The various features and advantages of this disclosure will become apparent to those skilled in the art from the following detailed description.

### BRIEF DESCRIPTION OF THE DRAWINGS

Certain exemplary embodiments will now be described in greater detail by way of example only and with reference to the accompanying drawings in which:
Figure 1 discloses a modeling system.
Figure 2 discloses a graphical depiction of a tessellated model.
Figure 3 discloses an arrangement of a tessellated model.
Figure 4A discloses a graphical user interface for depicting geometry.
Figure 4B discloses selected portions of the user interface of Figure 4A.
Figure 5 discloses an arrangement of the user interface of Figure 4A.
Figure 6 discloses another arrangement of the user interface of Figure 4A.
Figure 7 discloses another depiction of the geometry in the user interface of Figure 4A.
Figure 8 discloses model geometry including edges.
Figure 9 discloses curve objects including curves associated with the edges of Figure 8.
Figure 10 discloses a tessellation of the geometry of Figure 8.
Figure 11 discloses the user interface including curve objects.
Figure 12 discloses the activation of curve objects of Figure 11.
Figure 13 discloses a method of generating a tessellated model.

Like reference numbers and designations in the various drawings indicate like elements.

### DETAILED DESCRIPTION

Model-based definition (MBD) utilizing product manufacturing information (PMI) in a CAD file may highlight associated edges. Lightweight viewers may not have the same capability due to edge definition not being part of the lightweight model structure, making it difficult to interpret requirements designated for edges in the viewer.

Disclosed are techniques for identifying edges of geometry in a tessellated file. The PMI objects and associated edges in the CAD file may be evaluated when establishing the lightweight file. Curves may be extracted to be substantially or completely equivalent to the associated edges. The curves may be added to the PMI associations. The curves may be associated with respective annotation objects. The CAD model may be published as a tessellated model, which may include the curves and annotation objects. The curve objects and associated curves may be output with all other published objects with the associations intact to visually depict highlighting the edges (e.g., equivalent curves) in the viewer. The curves may not be saved in the original CAD file. Application programming interface (API) functions may be used to create the curves and associated curve objects. The API may not include the curve objects, but it may support field objects configured to depict the curves. The code (e.g., script) to generate the curves and curve objects may be embedded within the same tessellated file associated with the tessellated geometry. The tessellated file may be stored in a lightweight format, such as a Portable Document File (PDF) format. Accordingly, the lightweight viewer does not have to be programmed to support the curve objects and any lightweight viewer that supports the file format may access the tessellated model and curve objects.

The curves may selectively highlight edges associated with model geometry in the display window of the lightweight viewer. The lightweight viewer may present information relating to the associated geometric model. When the user selects an annotation object, the edge appears to be highlighted along the associated boundary of the geometry. The annotation is not associated with the original geometry, but the respective curve. Since the edges and associated annotations are embedded in the file, the lightweight viewer does not have to be programmed to support the edge highlighting feature.

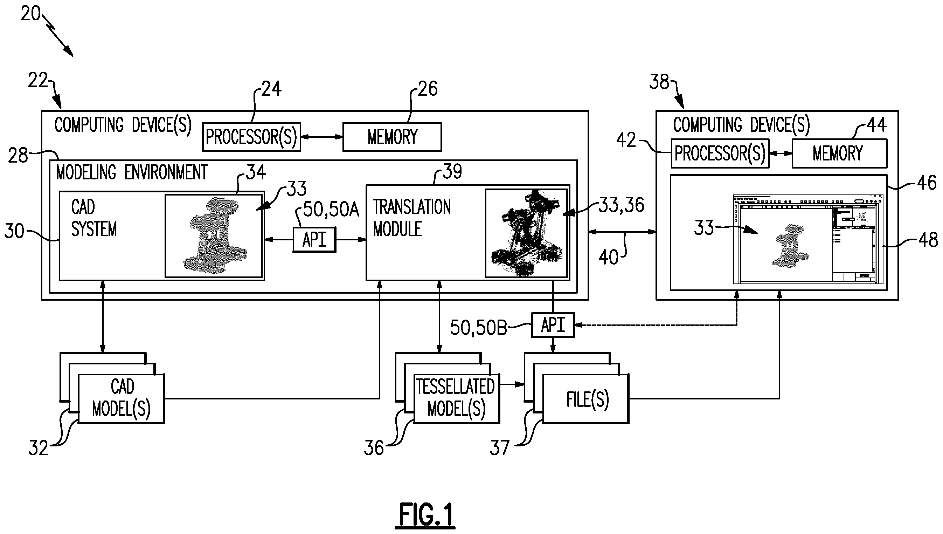

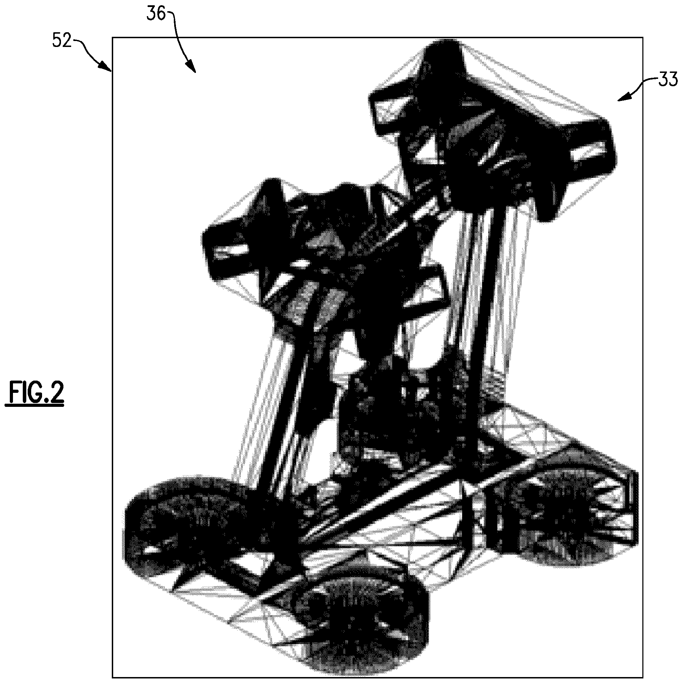

Figure 1 discloses a modeling system 20. The modeling system 20 may be operable to interact with one or more computer-aided design (CAD) models. The modeling system 20 may be operable to generate one or more tessellated models from the CAD model(s). The tessellated model may be relatively compact and may include a lesser amount of data compared to the CAD model. The tessellated model may represent CAD geometry as a set of facets (e.g., triangles) that may be patched together (see, e.g., Figure 2). Each of the facets may be defined by three respective points of a point cloud. The features disclosed herein may be incorporated into, or may otherwise be utilized with, a lightweight viewer. The tessellated models may be viewable in the lightweight viewer. For the purposes of this disclosure, a "lightweight viewer" is a software application suitable to view tessellated models. The lightweight viewer may be operable to view and interact with, but not edit, the tessellated model. Lightweight viewers may include a 3D PDF or HTML viewer or another viewer such as JT2Go operable to access tessellated models stored in a lightweight file format.

The modeling system 20 may include at least one computing device 22. The computing device 22 may include one or more processors 24 coupled to memory 26. The computing device 22 may be operable to execute a modeling environment (e.g., tool) 28. The modeling environment 28 may incorporate or may otherwise interface with a CAD system 30 (e.g., CATIA, AutoCAD, Solidworks, Siemens NX, etc.). The CAD system 30 and/or another portion of the modeling environment 28 may be operable to access one or more CAD models 32. Each of the CAD models 32 may be associated with geometry. The geometry may be associated with one or more virtual and/or physical components, assemblies and/or systems. The CAD system 30 may be operable to display one or more of the CAD models 32 in a user interface 34.

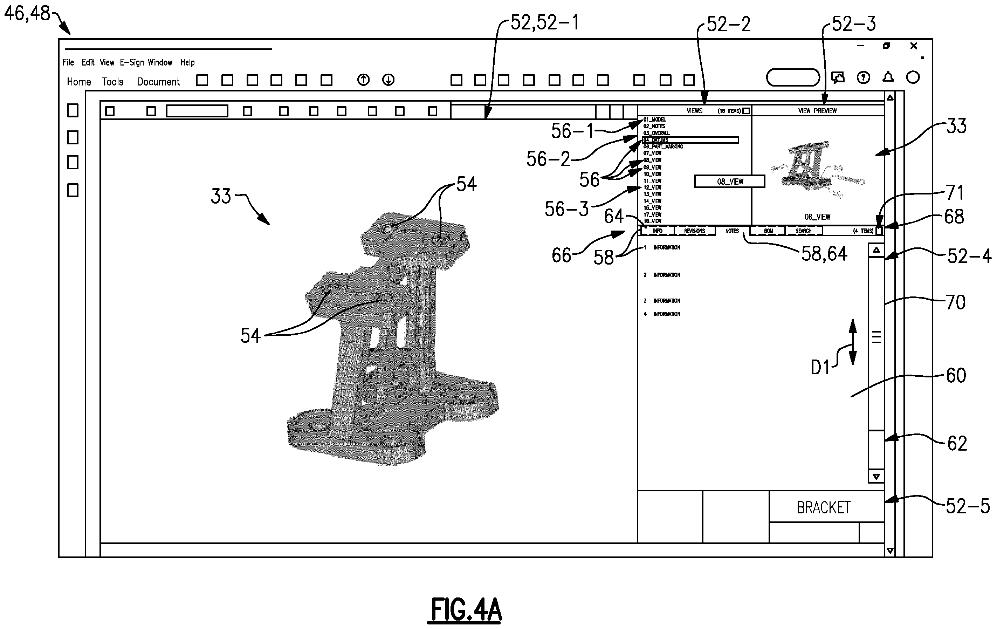

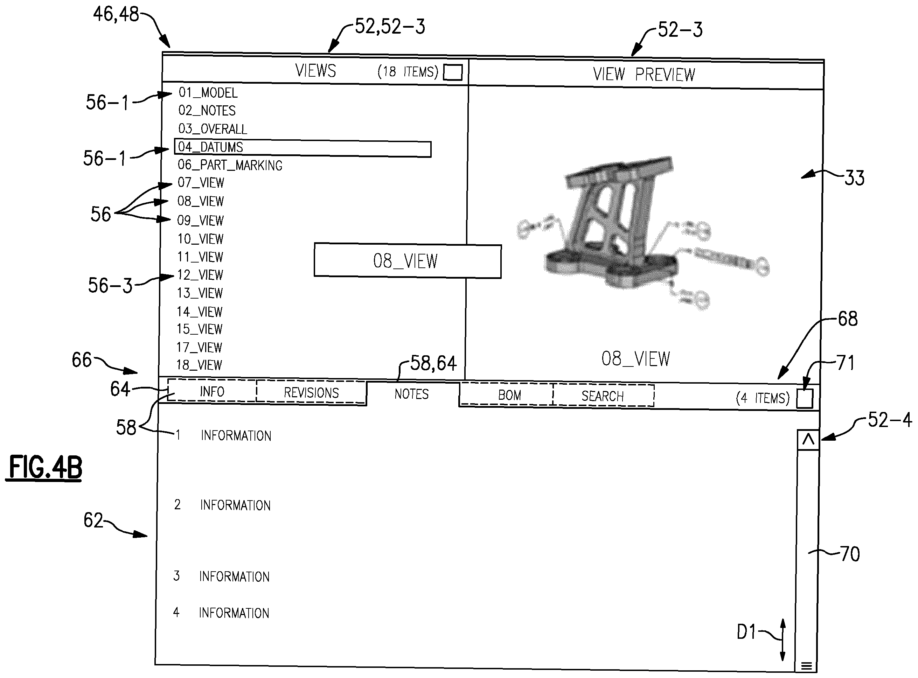

A user may desire to share or otherwise communicate information associated with the design to one or more other users, such as another member of a development team, a customer, or a supplier. The modeling environment 28 may be operable to generate one or more tessellated models 36, which may have a relatively lesser amount of information than the associated CAD model(s) 32 for communication to the other users. The tessellated model 36 may be stored in one or more lightweight files 37. The CAD model 32 and tessellated model 36 may be associated with geometry 33 (e.g., Figures 2 and 4A). The tessellated model 36 may exclude the exact CAD geometry and/or any CAD model 32 associated with the geometry 33.

Various users may access and review the tessellated models 36 in a lightweight viewer. Various lightweight viewers may be utilized, such as Adobe which may be operable to access PDF files. The lightweight viewer may be operable to access and view lightweight files containing tessellated models but not any files containing CAD models, including the exact CAD geometry. In other implementations, the modeling environment 28 may be operable to store the tessellated model 36 and the exact CAD geometry in the same file. Each of the tessellated models 36 may be associated with one or more respective CAD models 32 that store the exact CAD geometry and related information. Figure 2 discloses a graphical depiction of a tessellated model 36 according to an implementation. The specific geometry of the depicted tessellated model 36 is not intended to limit this disclosure.

The modeling environment 28 may be operable to access and display each of the tessellated models 36. In implementations, one or more (e.g., client) computing devices 38 may be operable to access the tessellated models 36. The computing devices 22, 38 may include one or more computer processors, memory, storage means, network devices, input and/or output devices, and/or interfaces. The computing devices 22, 38 may be operable to execute one or more software programs, including one or more portions of the modeling environment 28. The computing devices 22, 38 may be operable to communicate with one or more networks established by one or more computing devices. The memory may include UVPROM, EEPROM, FLASH, RAM, ROM, DVD, CD, a hard drive, or other computer readable medium which may store data and/or the functionality of this description. The computing devices 22, 38 may be a desktop computer, laptop computer, smart phone, tablet, or any other computer device. Input devices may include a keyboard, mouse, touchscreen, etc. The output devices may include a monitor, speakers, printers, etc. Each of the computing devices 38 may include one or more processors 42 coupled to memory 44. The computing device 38 may be coupled to the computing device 22 by connection(s) 40. The connection 40 may be a wired and/or wireless connection. The connection 40 may be established over one or more networks and/or other computing systems.

The processor 42 of the computing device 38 may be operable to execute a lightweight viewer 46. The lightweight viewer 46 may be a separate software application executable by the computing device 38 or may be a service provided by the computing device 22 which may be accessible by a thin client or browser over a network connection. The lightweight viewer 46 may be operable to access the tessellated models 36. The lightweight viewer 46 may be displayed in a display device. The lightweight viewer 46 may include a graphical user interface (GUI) 48 operable to display the tessellated model 36. The lightweight viewer 46 may be operable to read tessellated models 36 but not any CAD models 32, including CAD models 32 relating to geometry associated with the tessellated models 36.

Various techniques may be utilized to establish the tessellated models 36. The modeling environment 28 may be operable to generate one or more objects (e.g., elements), including any of the objects disclosed herein. In implementations, the objects may be field objects. The tessellated model 36 may include one or more field objects. The field objects and associated contents may be embedded within the tessellated model 36. The modeling environment 28 may include, or may otherwise interface with, one or more application programming interfaces (API) 50. In the implementation of Figure 1, the system 20 may include or otherwise interface with a first API 50A and a second API 50B. The functionality of the APIs 50A, 50B may be incorporated into a single API 50 or may be distributed between three or more APIs 50. The CAD system 30 and/or lightweight viewer 46 may be operable to interact with the respective CAD models 32 and tessellated models 36 according to the API 50. The lightweight viewer 46 may be configured to recognize objects, function calls, data structures, etc. specified in the API(s) 50. The API 50 may be utilized to establish one or more tessellated models 36. The API 50 may be utilized to convert the CAD models 32 to tessellated models 36. The modeling environment 28 may include a translation module 39 operable to establish tessellated models 36 and/or lightweight files 37. The translation module 39 may be operable to interact with the API 50B to establish (e.g., render) tessellated models 36. The translation module 39 may be operable to interact with the API 50B to establish lightweight files 37 including tessellated model(s) 36 in a format (e.g., data structure) supported by the API 50B and/or lightweight viewer 46. The API 50 may be utilized to assign various information, scripts and other data to one or more fields of the field objects. The field objects may be established according to data structure(s) specified in the API 50. The API 50 may provide the ability to associate scripts with objects of the tessellated model 36. The code (e.g., script) to generate the disclosed features and/or any code that causes any associated functions to occur in the lightweight viewer (e.g., in response to selection of the objects of the model 36) may be embedded within the same lightweight file 37 as the objects of the model 36 associated with the model geometry 33. The scripts and other code may be executed in response to user interaction and/or selection of the respective field object. The script may be specified according to JavaScript or another scripting language supported by the API 50. Storing the code that causes the function(s) associated with the objects and other features in the lightweight file 37 itself allows for the publisher to control the file presentation directly and does not require a special viewer.

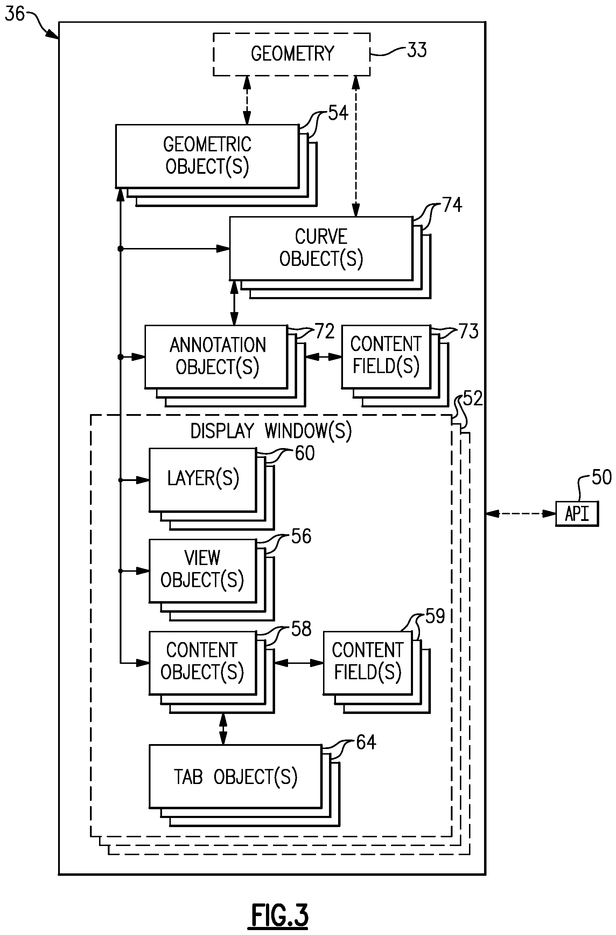

Figure 3 schematically illustrates a tessellated model 36 according to an implementation. The tessellated model 36 may include any of the objects and associated structures disclosed herein. The tessellated model 36 may be established with respect to one or more data structures specified in the API 50. Various techniques may be utilized to establish relationships between the various objects of the tessellated model 36, including one or more static and/or dynamic links which may be specified in field(s) of the field objects. The API 50 may be utilized to establish the objects and links.

Referring to Figure 4A, with continuing reference to Figures 1-3, the tessellated model 36 may establish a user interface 48. The user interface 48 may be suitable for a lightweight viewer, such as lightweight viewer 46, which may display the tessellated model 36 according to the API 50. Figure 4A discloses an implementation of the lightweight viewer 46. The tessellated model 36 may include the tessellated geometry, information associated or presented with the tessellated geometry, and/or information utilized to establish the user interface 48.

The user interface 48 may be arranged in a manner that may declutter secondary information associated with the design geometry 33 such that a main viewing area may be relatively large. The user interface 48 may include one or more display windows 52 which may serve to divide the user interface 48 into different areas. In the implementation of Figure 3, the display windows 52 may include a first (e.g., main) viewing window 52-1, a second (e.g., navigation) window 52-2, a third (e.g., preview) window 52-3, a fourth (e.g., information) window 52-4, and a fifth (e.g., information) window 52-5. The information window 52-4 may be a dynamic information window that may dynamically display information. The information may be contextual depending on what view the user may select. The information window 52-5 may be a persistent information window, which may always be visible in the user interface 48 and may display information without change. The information may include the title, part number, document number, etc. that may uniquely identify the design. Although the user interface 48 is shown with five display windows 52, it should be understood that fewer or more than five display windows 52 may be utilized in accordance with the teachings disclosed herein. The viewing window 52-1 and/or preview window 52-3 may be operable to display one or more depictions of the geometry 33. The windows 52-2, 52-4 and/or 52-5 may be operable to display various information relating to the geometry 33 and/or other aspects of the design. In implementations, the window(s) 52 may be operable to display information associated with one or more attributes specified in the lightweight file 37. Attribute(s) may be associated with the geometry 33 and/or depictions (e.g., views) of the geometry 33, but some attribute(s) may be specified at a global (e.g., file) level. The attributes may be specified in a header of the file 37.

The modeling environment 28 may be operable to generate one or more geometric objects 54. The modeling environment 28 may be operable to generate a tessellated model 36 that includes the geometric object(s) 54. The geometric objects 54 may establish a tessellation of geometry 33 (see, e.g., Figure 2). The viewing window 52-1, preview window 52-3 and/or another display window 52 may be operable to display geometry 33 established by one or more geometric objects 54 of the tessellated model 36. The geometric objects 54 may be operable to display various depictions of the tessellation of the geometry 33 in the viewing window 52-1 and/or another window 52 of the user interface 48. Each of the geometric objects 54 may be associated with one or more graphics that may depict a geometry of the design. The depictions may include two-dimensional and/or three-dimensional views of the geometry 33 and may include solids, wireframes, transparencies, etc. The modeling environment 28 may be operable to store the tessellated models 36 in one or more lightweight files 37, which may be readable by the lightweight viewer 46. In implementations, the file(s) 37 may exclude any CAD models 32, including any CAD models 32 utilized to establish, or that may otherwise be related to, tessellated model(s) 36 of the respective geometry 33. The modeling environment 28 may be operable to store code (e.g., scripts, function calls, etc.) in the lightweight file 37 that may be operable to cause one or more functions associated with the tessellated model 36 to execute in the lightweight viewer 46, including any of the functions disclosed herein.

The modeling environment 28 may be operable to generate one or more view objects 56. Each of the view objects 56 may be associated with respective depictions of the geometric object(s) 54 associated with the geometry 33. The view objects 56 may be associated with the navigation window 52-2 and/or another window 52 of the user interface 48. The navigation window 52-2 may be operable to display one or more of the view objects 56, which may be depicted in a list. The viewing window 52-1 may be operable to display the depiction in response to user interaction or selection of the respective view object 56.

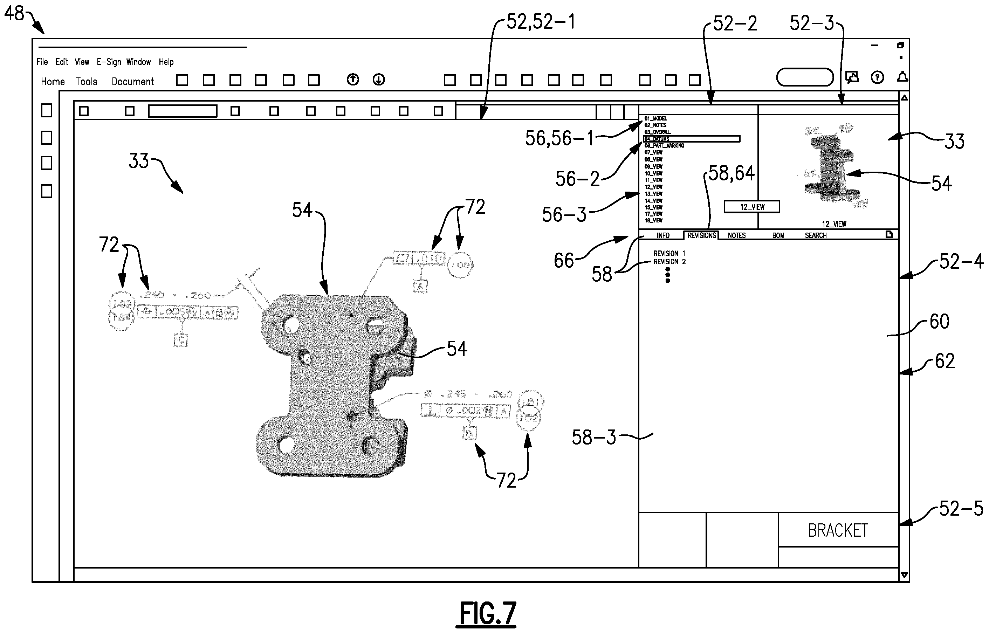

In implementations, the view objects 56 may include first, second, and third view objects 56-1 to 56-3. The view object 56-1 may be associated with an overall representation of the geometry 33. The second view object 56-2 may be associated with another depiction of the geometry 33, such as a depiction including one or more datums or other annotations (see, e.g., Figure 7). The viewing window 52-1 may be operable to display the depiction of the geometry 33 in response to selection of the respective view object 56. The preview window 52-3 may be operable to display a depiction of the geometry 33 associated with the respective view object 56 in response to user interaction. In implementations, a user may interact with the user interface 48 by positioning a cursor on or otherwise adjacent to the view object 56 to cause the preview window 52-3 to display the respective depiction (e.g., preview) of the geometry 33, which may be displayed in the viewing window 52-1 in response to selection of the view object 56 (e.g., mouse click).

The information window 52-4 may be operable to display information in the user interface 48. The information may be generic and/or may be associated with the geometry 33. The information window 52-4 may be dynamically linked to one or more of the geometric objects 54 such that selection of the geometric object 54 may cause information to update in the information window 52-4.

The modeling environment 28 may be operable to generate one or more content objects 58. The tessellated model(s) 36 may include the content object(s) 58. The content object(s) 58 may be operable to establish the information window 52-4. The content objects 58 may be operable to selectively display information associated with the tessellated model 36 and/or respective geometry 33 in a common display region 62 and/or another portion of the user interface 48. The content objects 58 may be operable to establish the information window 52-4 such that the common display region 62 may be spaced apart from, but may be concurrently displayed with, the viewing window 52-1 in response to opening the tessellated model 36 in the lightweight viewer 46.

The content objects 58 may be assigned various information, including information associated with the tessellated model 36. The information may be assigned to content fields 59 associated with the respective content objects 58 (Figure 3). In implementations, the content fields 59 may be associated with information specified in a data structure (e.g., template) readable by the lightweight viewer 46. The lightweight file 37 may store the information in the data structure according to the API 50. In other implementations, the information may be stored directly in the respective content fields 59. The content field 59 may be a portion of the content object 58 or may be another object linked to the content object 58. Various techniques may be utilized to define the information associated with the content fields 59, including various data types or structures such as character, string, integer, boolean, array, date, time, etc. In implementations, the content fields 59 may contain code (e.g., script), which may be executable by the API 50 and/or lightweight viewer 46. The information assigned to the content objects 58 may be the same or may at least partially differ from information assigned to other content objects 58. The information may be associated with various details of the organization responsible for the CAD model 32. The information may include a revision history of the CAD model 32, various notes or statements associated with the CAD model 32, a bill of material (BOM) associated with component(s) represented by the geometry 33, etc. The content objects 58 may be operable to display information assigned to the respective content field 59 in respective portions of the information window 52-4.

The modeling environment 28 may be operable to generate one or more content layers 60. The layers 60 may be respective objects of the tessellated model 36. Each content object 58 may be associated with one or more of the layers 60. The content objects 58 may be assigned (e.g., occupy) the same view location in the user interface 48 but may be assigned to different layers 60 of the model 36. At least some of the layers 60 may occupy the common display region 62 of the user interface 48. The layers 60 may be dimensioned to at least partially, substantially, or completely overlap with each other in the common display region 62. The content objects 58 may be operable to selectively display information associated with the tessellated model 36 in response to user interaction with or selection of the respective content object 58 such that the respective layer 60 may be activated, but a remainder of the layers 60 may be deactivated in the common display region 62.

Various techniques may be utilized to establish the layers 60 in the user interface 48. The modeling environment 28 may be operable to establish a tabbed interface 66. The tabbed interface 66 may be utilized to display information relating to the geometry 33 and/or other aspects of the tessellated model 36. Each viewable tab of the tabbed interface 66 may be established by at least two objects. One object may be associated with the tab name (e.g., tab object 64) and another object may be associated with the respective information area (e.g., content object 58). The user may interact with a control object 71 in the user interface 48 to open a separate document containing a full listing of applicable tabs. Prior systems may include a model tree window having one or more tabs for displaying various information, such as a model tree, model views, product manufacturing information (PMI), etc., specified in a data stack. However, the model tree window may be provided by the application itself independent of any particular lightweight file, instead of being established by objects stored in the lightweight file.

The modeling environment 28 may be operable to generate one or more tab objects 64. The tessellated model 36 may include the tab objects 64. The information window 52-4 may be established by the tab object(s) 64 and control objects 58. The tab objects 64 may be operable to graphically depict the tabbed interface 66 in the information window 52-4 or another portion of the user interface 48. The tab objects 64 may be arranged in an array to graphically depict the tabbed interface 66. The tab objects 64 may be arranged in a row or may otherwise be offset from each other. The tabbed interface 66 may be directly adjacent to the common display region 62. The tab objects 64 may be associated with one or more content objects 58. Each tab object 64 may be associated with a respective layer 60 and one or more content objects 58 assigned to the layer 60. Each of the layers 60 and/or respective tab objects 64 may be associated with an activated state and a deactivated state. The tab objects 64 may be operable to graphically depict the current states in the user interface 48. The layers 60 may be made visible or invisible based on selection of the tab object 64. One layer 60 may be selectively visible at a time. Each of the tab objects 64 may be operable to selectively activate the layer 60 of the respective content object(s) 58 and deactivate a remainder of the layers 60 associated with the information window 52-4 in response to user interaction or other selection of the respective tab object 64.

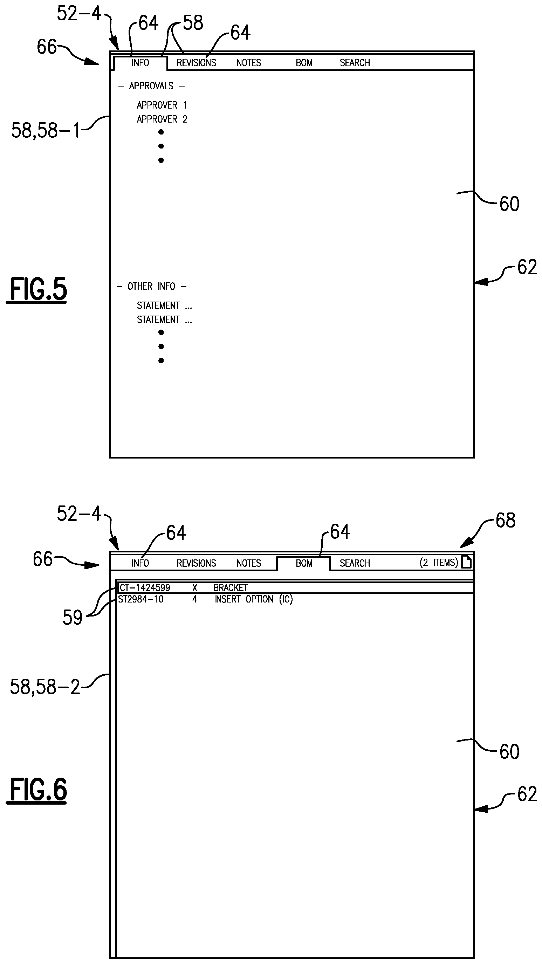

In the implementation of Figure 5, the content objects 58 may include a first content object 58-1. The content object 58-1 may be associated with various information relating to personnel(s) and/or organization(s) assigned to designing, reviewing, manufacturing, etc., of the component(s), assembly or system.

The modeling environment 28 may be operable to dynamically link one or more of the content objects 58 to one or more of the view objects 56 such that contents of a list or other information assigned to the content objects 58 may update in response to user interaction with or selection of the respective view objects 56. One or more of the content objects 58 may be dynamically linked to one or more of the view objects 56 such that the content fields 59 and/or other information assigned to the respective content objects 58 may update in response to selection of the respective view object 56. In the implementation of Figure 6, the content objects 58 may include a second content object 58-2. The second content object 58-2 may be operable to display a bill of material (BOM) associated with the design. The content fields 59 of the associated content object 58-2 may be depicted graphically as a list. In implementations, the list may be an interactive list. The content fields 59 associated with the respective content object 58-2 may be dynamically linked to one or more of the respective view objects 56. Selection of a respective view object 56 from the navigation window 52-2 may cause the interactive list to update such that content of the content fields 59 associated with the respective content object 58 may be displayed in the common display region 62 according to the selected view object 56. The content displayed in the list may include unique identifiers (e.g., part numbers, names, descriptions, etc.) assigned to the associated geometric objects 54 and related information (see, e.g., Figures 4A-4B). In implementations, the content object 58-2 may include a content field associated with each of the respective geometric objects 54. The content object 58-2 may be operable to selective display of content in the content fields 59 in response to selection of the respective view object 56.

The information displayed in the information window 52-4 may include one or more statements. The statements may be established by one or more respective content fields 59. The content objects 58 may be operable to establish a list associated with a quantity of the statements assigned to the content fields 59 of the respective content object 58.

Each tab may be associated with a counter. The content objects 58 may be associated with a counter object 68 that may establish the counter. The counter object 68 may be arranged adjacent to the common display region 62. The counter object 68 may be operable to indicate a quantity of the statements assigned to the respective content objects 58 that may be currently indicated in the list.

Referring back to Figures 4A-4B, each tab may be associated with a control object 70 for interacting with information in the tabbed interface 66. The user may interact with the control object 70 to view the associated information, which may be useful in decluttering the information window 52-4 by reducing the size of the information area. One or more of the content objects 58 may be associated with the control object 70. The control object 70 may be adjacent to the common display region 62. The tessellated model 36 may include the control object 70. The control object 70 may be operable to cause a visible portion of the activated layer 60 to vary in response to user interaction. The control object 70 may be a scroll bar object. The scroll bar object 70 may be moveable in direction D1. The scroll bar object 70 may be manipulated by the user to view information displayed in the common display region 62. The counter object 68 may indicate that related content is available, which may be useful by suggesting that the user may interact with the scroll bar object 70 to view the additional information.

Referring to Figures 3 and 7, the modeling environment 28 may be operable to generate one or more annotation objects 72. The tessellated model 36 may include the annotation object(s) 72. The annotations objects 72 may be assigned information associated with one or more respective geometric objects 54. The information may include one or more annotations specified by the design. The information may be stored in content field(s) 73 of the annotation object(s) 72 (Figure 3). The information associated with the annotation objects 72 may be the same or may be different. Each of the annotation objects 72 may be operable to depict the respective information as a graphical annotation in the viewing window 52-1. The graphical annotation may be depicted adjacent to the geometry 33. Each annotation object 72 may be associated with one or more view objects 56. In implementations, each annotation object 72 may be linked to a single view object 56 such the set of annotations may differ for the depictions of the geometry 33.

The CAD models 32 may have faces and edges associated with the same geometry (e.g., a planar side of a part). Annotations may be associated with the edges. The CAD system 30 may be configured to highlight the edges in response to selection of the respective annotation. However, when the CAD model 32 is exported to a tessellated model format for viewing in the lightweight viewer 46, the selection of the annotation in the lightweight viewer 46 may not result in highlighting of the respective edge. This is because the model 36 is tessellated and the geometry 33 is represented by a set of triangles; the edges of the CAD model 32 are lost. The disclosed techniques may be utilized to selectively highlight or otherwise identify edges associated with the geometry in the tessellated model 36.

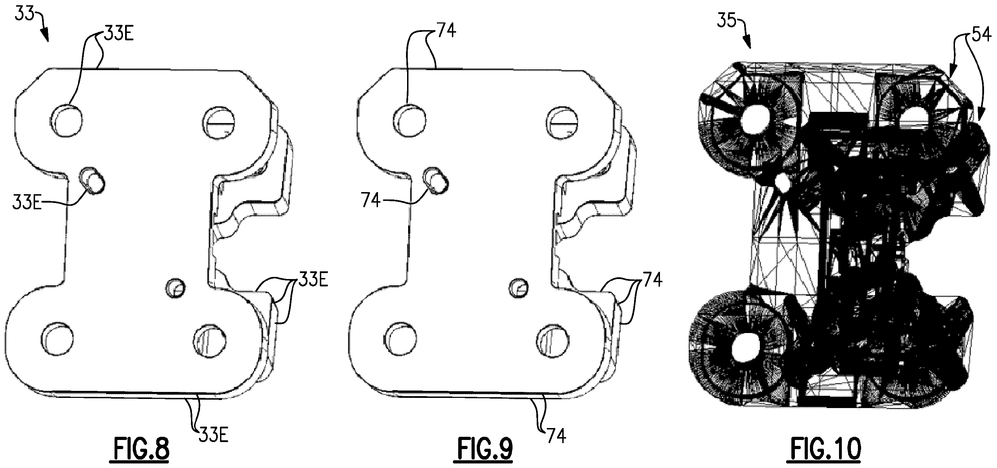

Referring to Figure 8, with continuing reference to Figures 3 and 7, the geometric objects 54 may be associated with respective edges 33E of the geometry 33. One or more of the annotation objects 72 may be assigned information associated with the respective edges 33E of the geometry 33. The respective information can include information associated with dimensions of the respective edges 33E (e.g. a radius and/or length of the respective edge), tolerances, and/or other PMI. The information may be stored in respective content fields 73. Each of the annotation objects 72 may be operable to depict the respective information as a graphical annotation in the viewing window 52-1.

The edge definition may be omitted from the tessellation of the CAD model 32. The edges 33E of the geometry 33 may be established by a set of triangles in the tessellated model 36. Figure 10 discloses a tessellation 35 of the geometry 33 according to an implementation.

Referring to Figure 9, with continuing reference to Figures 3 and 7-8, the techniques disclosed herein may be utilized to generate one or more curve objects 74 that may be stored in the tessellated model 36 to represent the edge definition. The modeling environment 28 may be operable to generate one or more curve objects 74. Each of the curve objects 74 of the tessellated model 36 may be associated with one or more of the annotation objects 72. The curve objects 74 may be associated with, but may be distinct from, the edges 33E of the geometry 33. Each of the curve objects 74 may include respective curves dimensioned to follow the respective edges 33E of the geometry 33. Each of the curve objects 74 may be operable to selectively depict the respective edges 33E of the geometry 33 in the viewing window 52-1 in response to selection of the respective annotation object 72. The curve objects 74 may be separate and distinct from the geometric objects 54 and tessellation 35.

The modeling environment 28 may be operable to extract the edges 33E of the geometry 33 in the CAD model 32 as a set of curves that may differ from the tessellation 35 of the geometry 33. The modeling environment 28 may be operable to establish a curve object 74 for each respective edge 33E of the geometry 33. The modeling environment 28 may be operable to assign the set of curves to the respective curve objects 74. Each of the curve objects 74 may be operable to depict the respective curve as a straight line, an arc, or a complex curve in the viewing window 52-1. The modeling environment 28 may be operable to generate a tessellated model 36 that may include the tessellation 35 associated with the geometric object(s) 54, annotation object(s) 72, and curve object(s) 74. The geometric objects 54 may be operable to display the tessellation 35 of the geometry 33 in the viewing window 52-1 and/or preview window 52-3 of the user interface 48.

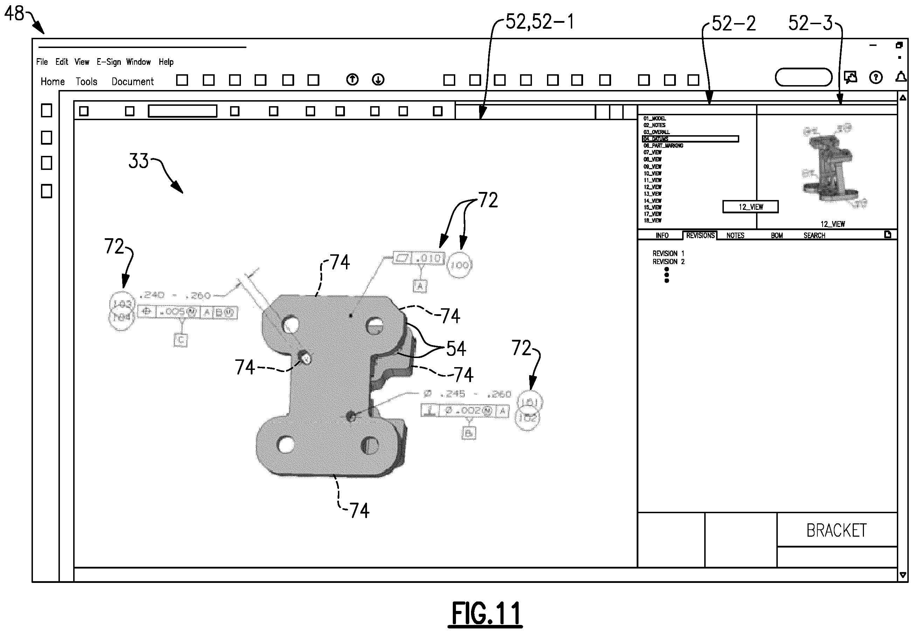

Referring to Figure 11, with continuing reference to Figures 3 and 8-10, each of the annotation objects 72 may be operable to depict the respective information as a graphical annotation in the viewing window 52-1. One or more of the geometric objects 54 may be operable to depict a boundary associated with the geometry 33. The boundary may be associated with one or more edges 33E of the geometry 33.

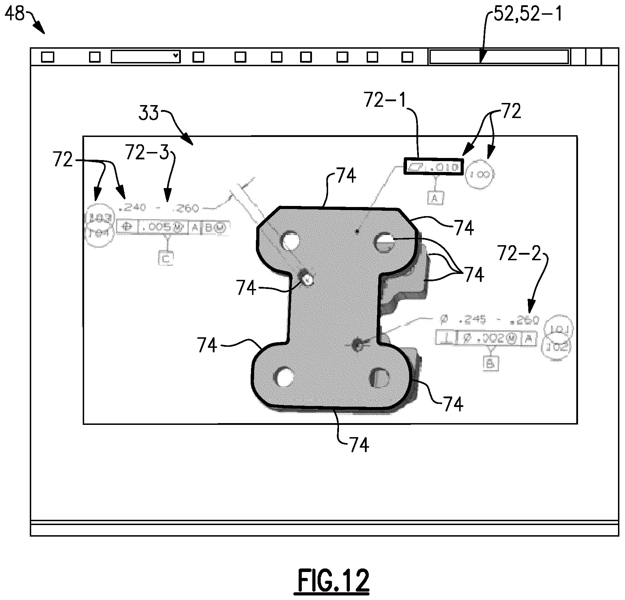

Referring to Figure 12, with continuing reference to Figures 3 and 8-11, the curve objects 74 may be operable to visually enhance a boundary of the geometry 33. The boundary may be associated with a face and/or edge 33E of the geometry 33. One or more of the geometric objects 54 may be operable to depict the boundary by one or more triangles established by the tessellation 35 of the geometry 33 (see, e.g., Figure 10).

Each of the curve objects 74 may be operable to selectively depict the respective edges 33E of the geometry 33 in the viewing window 52-1 in response to selection of the respective annotation object 72. In the implementation of Figure 12, the annotation objects 72 may include a first annotation object 72-1, a second annotation object 72-2, and a third annotation object 72-3. Selection of the annotation object 72-1 may cause each curve object 74 associated with the annotation object 72-1 to highlight or otherwise visually enhance any of the respective edges 33E in the viewing window 52-1 (shown as thickened line segments for illustrative purposes). The curve objects 74 may be operable to visually enhance segments of the geometric object(s) 54 associated with respective edges 33E. Various techniques may be utilized to visually enhance the curve objects 74, including thickness, color, shading, etc. that may be visually distinct from the geometry of the associated geometry object 54.

Selection of the annotation object(s) 72 may cause the viewing window 52-1 to highlight the boundary of the respective geometric object(s) 54. One or more of the curve objects 74 may be selectively activated in response to selection of the respective annotation object 72 but not in response to selection of any of the geometric objects 54 in the viewing window 52-1. The curve objects 74 can include two or more curve objects 74 that may be associated with respective annotation objects 72. Each curve object 74 may be operable to deactivate a remainder of the curve objects 74 in response to selection of the respective annotation object 72 such that only one of the curve objects 74 may be depicted in the viewing window 52-1 at a time. In other implementations, the user may select two or more annotation objects 72 such that two or more respective curve objects 74 are displayed together in the viewing window 52-1. Utilizing the techniques disclosed herein, the user may interact with the user interface 48 to selectively highlight or otherwise view edge geometry associated with the annotation of interest.

Various techniques may be utilized to selectively highlight or otherwise identify the edge geometry in the tessellated model 36. The edges of the geometric objects in the CAD model 32 may be extracted as curves. This may include determining the boundaries of the geometric object. The curves may be generated as separate geometric objects of the CAD model 32. In implementations, curves are a CAD object type, which can be used to generate straight lines, arcs, splines and other complex curves. The curves may be associated with respective annotations which may be objects. The annotation may not be associated with the edge of the original/base geometrical object, but the respective curve. In other implementations, the annotation may be associated with both the edge of the original/base geometrical object and the respective curve. The API may be utilized to associate the annotations with the respective curves which may be embedded within the published file containing the tessellated model 36. The CAD model 32 may be published as a tessellated model 36, which may include the curves and annotation objects 72. When the user selects (e.g., activities) an annotation object 72 in the user interface 48, the edge(s) appear to be highlighted along the associated boundary of the geometry 33. Since the edges and associated annotation objects 72 are embedded in the file, the lightweight viewer 46 does not have to be programmed to support the edge highlighting feature and any lightweight viewer that supports the file format may access the model and associated edge highlighting features. The tessellated model 36 may be presented to the user in a manner that suggests that the annotation is associated with the base object of the CAD model 32, but it is not. The annotation object 72 may be associated with the curve, which occupies the same location as a boundary of the geometry 33 associated with the base object (e.g., edge of planar face of component). The depiction of the annotation object 72 may be adjacent to geometry 33 associated with the base object but it may not be associated with the base object itself because the base object may not exist in the tessellated model 36. Instead, the base object may be represented by a set of triangles. The curves, on the other hand, may stay as curves when the CAD model 32 is published as the tessellated model 36.

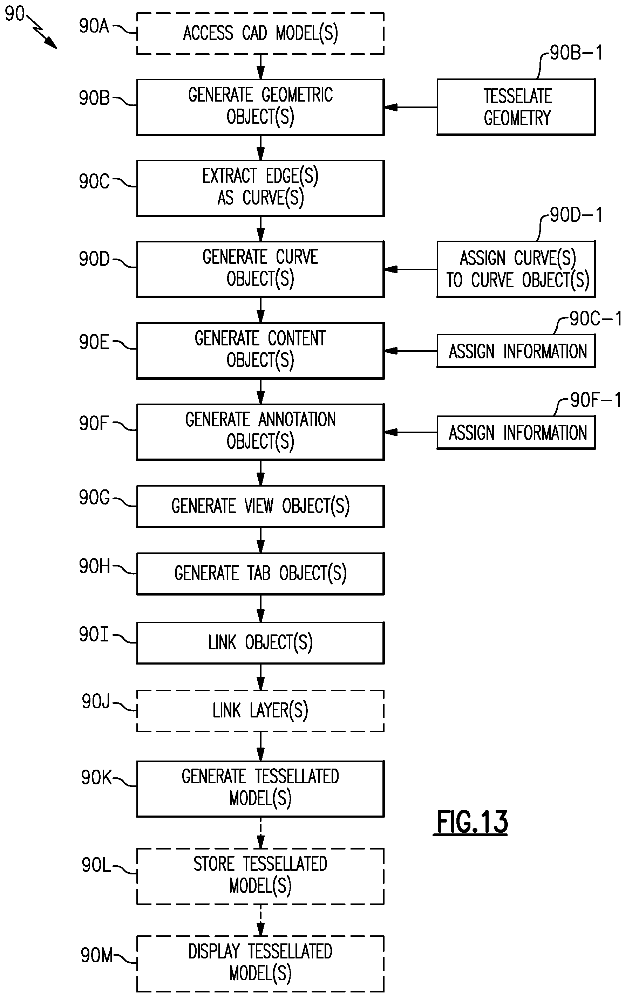

Figure 13 discloses a method of establishing and/or interacting with a tessellated model in a flow chart 90 according to an implementation. The method 90 may be utilized to generate one or more tessellated models associated with design geometry. The geometry may be defined in one or more associated CAD models. The tessellated models may exclude any CAD models associated with the geometry. Fewer or additional steps than are recited below could be performed within the scope of this disclosure, and the recited order of steps is not intended to limit this disclosure. The modeling environment 28 may be programmed with logic for performing method 90. Reference is made to the system 20.

Referring to Figure 1, with continuing reference to Figure 13, one or more CAD models 32 may be accessed at step 90A. The CAD model 32 may be associated with respective geometry 33. A CAD system 30 may be utilized to define the geometry 33 in the CAD model 32.

Referring to Figures 2-4A, with continuing reference to Figures 1 and 13, one or more geometric objects 54 may be generated at step 90B. The geometric objects 54 may establish a tessellation of the geometry 33, which may be stored in a tessellated model 36. The geometric objects 54 may be operable to display the tessellation of geometry 33 in the viewing window 52-1 and/or another display window 52 of the user interface 48. Generating the geometric objects 54 at step 90B may include tessellating the geometry 33 at step 90B-1 (see, e.g., Figure 10).

At step 90C, the edges 33E of the geometry 33 in the CAD model 32 may be extracted as a set of one or more curves. The curves may be separate and distinct from the tessellation of the geometry 33 established at step 90B-1.

At step 90D, one or more curve objects 74 may be generated. Step 90D may include assigning the extracted curve(s) to the curve objects 74 at step 90D-1. Each of the curves extracted at step 90C may be associated with a respective curve object 74. Each of the curve objects 74 may be operable to selectively depict the edge(s) 33E of the geometry 33 in the viewing window 52-1 in response to selection of the respective annotation object 72.

Referring to Figures 3-4, with continuing reference to Figures 1 and 13, one or more content objects 58 may be generated at step 90E. The content objects 58 may be operable to establish the information window 52-4 of the user interface 48. Step 90E may include associating the content objects 58 with respective layers 60 that may occupy the common display region 62 of the user interface 48. The content objects 58 may be operable to establish the information window 52-4 such that the common display region 62 may be spaced apart from, but may be concurrently displayed with, the viewing window 52-1 in the user interface 48.

At step 90E-1, information associated with the geometry 33 and/or other information may be assigned to the content objects 58. In implementations, the information may be stored in one or more content fields 59. The information may be displayed utilizing any techniques disclosed herein. The content objects 58 may be operable to selectively display the respective information in the common display region 62 of the user interface 48.

At step 90F, one or more annotation objects 72 may be generated. Generating the annotation objects 72 may include assigning information associated with annotations of the geometric objects 54 to the content field(s) 73 of the respective annotation object(s) 72 at step 90E-1. Each of the annotation objects 72 may be operable to depict the respective information as a graphical annotation in the viewing window 52-1. The graphical annotation can include any of the annotations disclosed herein, such as identifiers, datums (e.g., dimensions, tolerances, etc.), and other information that may be associated with the geometric objects 54 and/or geometry 33 of the design. Assigning the information at step 90E-1 may include assigning the content field 73 of each of the annotation objects 72 to at least one or more of the annotation types. The assigned annotation type may be specified in a separate content field 73 of the annotation object 72. The annotation types may include any of the annotation types disclosed herein.

At step 90G, one or more view objects 56 may be generated. The view objects 56 may be associated with respective depictions of the geometry 33.

At step 90H, one or more tab objects 64 may be generated. The tab objects 64 may be operable to depict the tabbed interface 66 in the information window 52-4. Each tab object 64 may be associated with one or more of the content objects 58.

At step 901, one or more of the objects may be linked to other object(s) of the tessellated model 36, including any of the objects disclosed herein. The objects may include the geometric objects 54, view objects 56, content objects 58, tab objects 64, counter objects 68, control objects 70, annotation objects 72 and/or curve objects 74. Linking the objects at step 90I may include linking the annotation object(s) 72 to one or more of the curve objects 74. One or more of the annotation objects 72 may be linked to two or more of the curve objects 74. In implementations, two of the annotation objects 72 may be linked to one or more of the same curve object(s) 74.

At step 90J, one or more of the objects may be linked to one or more respective layers 60. Each of the tab objects 64 may be operable to selectively activate the layer 60 of the respective content object(s) 58 and deactivate the remainder of the layers 60 associated with the information window 52-4 and/or another portion of the user interface 48 in response to user interaction with or selection of the respective tab object 64.

At step 90K, one or more tessellated models 36 may be generated. The tessellated models 36 may be generated utilizing any of the techniques disclosed herein. The tessellated model 36 may include any of the objects and features disclosed herein, such as the geometric objects 54, content objects 58, layers 60, tab objects 64, counter objects 68, control objects 70, annotation objects 72, and/or curve objects 74. The curve objects 74 may be operable to graphically depict respective segments of the geometric objects 54 associated with the edges 33E of the geometry 33. The segments may be established by two or more triangles arranged along the associated segment.

Linking the objects at step 90I may include dynamically linking one or more of the content objects 58 to one or more of the view objects 56 such that the information assigned to the respective content object 58 may update in response to user action with the respective view object 56. In implementations, the content objects 58 may be operable to display a list of the information which may be dynamically updated in response to selection of the view object 56.

At step 90L, the tessellated model(s) 36 may be stored in one or more lightweight files 37. The files 37 may exclude the CAD model(s) 32 associated with the respective geometry 33.

At step 90M, the tessellated model(s) 36 may be displayed in a lightweight viewer 46. Step 90M may include establishing the user interface 48 in the display according to the objects of the tessellated model 36. The tessellated model 36 may cause the lightweight viewer 46 to execute code including one or more scripts, which may be specified in the content fields 59 of the content objects 58 or may otherwise be embedded in the tessellated model 36. Step 90M may include displaying one or more depictions of the geometry 33 in the display window(s) 52. Step 90M may include displaying one or more of the curve objects 74 in response to selection of a respective annotation object 72 in the user interface 48. Selection of the respective annotation object 72 may cause the viewing window 52-1 to highlight a boundary of the respective geometric object(s) 54. The geometric objects 54 may be operable to depict the boundary by triangles established by the tessellation 35 of the geometry 33.

The systems and methods disclosed herein may be utilized to generate tessellated models associated with geometry of one or more components, assemblies and/or systems. The tessellated models may be stored in relatively compact files, which may be readable by a lightweight viewer provided to users who may not have access to a CAD system. Having the curves associated to the PMI in the lightweight viewer may provide highlighting of the edges associated to a design requirement to ensure requirements are fully understood by the user.

Although the different examples have the specific components shown in the illustrations, embodiments of this disclosure are not limited to those particular combinations. It is possible to use some of the components or features from one of the examples in combination with features or components from another one of the examples.

Although particular step sequences are shown, described, and claimed, it should be understood that steps may be performed in any order, separated or combined unless otherwise indicated and will still benefit from the present disclosure.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A user interface (48) for a lightweight viewer (46) comprising:
a viewing window (52-1) operable to display geometry (33) established by one or more geometric objects (54) of a tessellated model (36), wherein the one or more geometric objects are associated with respective edges (33E) of the geometry, one or more annotation objects (72) of the tessellated model are assigned information associated with the respective edges, and the one or more annotation objects are operable to depict the respective information as a graphical annotation in the viewing window; and
wherein one or more curve objects (74) of the tessellated model are associated with the respective one or more annotation objects and include respective curves dimensioned to follow the respective edges of the geometry, and the one or more curve objects are operable to selectively depict the respective edges of the geometry in the viewing window in response to selection of the respective annotation object.

2. The user interface as recited in claim 1, wherein the one or more curve objects are operable to visually enhance respective segments of the one or more geometric objects associated with the respective edges.

3. The user interface as recited in claim 1, wherein selection of the one or more annotation objects causes the viewing window to highlight a boundary of the respective one or more geometric objects; and, optionally,
wherein the one or more geometric objects are operable to depict the boundary by a set of triangles established by tessellation (35) of the geometry.

4. The user interface as recited in claim 1, wherein the one or more curve objects are selectively activated by selection of the respective one or more annotations but not by selection any of the one or more geometric objects in the viewing window; or wherein each of the one or more curve objects is operable to depict the respective curve as a straight line, an arc, or a complex curve in the viewing window; or
wherein the tessellated model excludes any CAD model that establishes the geometry.

5. A system (20) for generating a tessellated model comprising:
a computing device (22, 38) including one or more processors (42) coupled to memory (44);
wherein the computing device is operable to execute a modelling environment (28), and the modeling environment is operable to:
access a computer-aided design (CAD) model (32) associated with geometry (33);
generate one or more geometric objects (54) that establish a tessellation (35) of the geometry in the CAD model;
generate one or more annotation objects (72) assigned information associated with the respective one or more geometric objects;
extracting edges (33E) of the geometry in the CAD model as a set of curves that differ from the tessellation of the geometry;
generating one or more curve objects (74);
assigning the set of curves to the respective one or more curve objects, the one or more curve objects associated with the respective one or more annotation objects;
generate a tessellated model (36) including the one or more geometric objects, the one or more annotation objects and the one or more curve objects;
wherein the one or more geometric objects are operable to display the tessellation of the geometry in a viewing window (52-1) of a user interface (48);
wherein the one or more annotation objects are operable to depict the respective information as a graphical annotation in the viewing window; and
wherein the one or more curve objects are operable to selectively depict the respective edges of the geometry in the viewing window in response to selection of the respective annotation object.

6. The system as recited in claim 5, wherein the one or more curve objects are operable to visually enhance a boundary of the respective geometry; and, optionally wherein the one or more geometric objects are operable to depict the boundary by one or more triangles established by the tessellation of the geometry.

7. The system as recited in claim 5, wherein the one or more curve objects are selectively activated in response to selection of the respective one or more annotation objects but not in response to selection any of the one or more geometric objects in the viewing window.

8. The system as recited in claim 5, wherein the one or more annotation objects include a plurality of annotation objects, the one or more curve objects include a plurality of curve objects associated with the respective annotation objects, and each of the curve objects is operable to deactivate a remainder of the curve objects in response to selection of the respective annotation object.

9. The system as recited in claim 5, wherein each of the one or more curve objects is operable to depict the respective curve as a straight line, an arc, or a complex curve in the viewing window.

10. The system as recited in claim 5, wherein the modeling environment is operable to:
store the tessellated model in a file readable by a lightweight viewer.

11. The system as recited in claim 10, wherein the file excludes the CAD model.

12. The system as recited in claim 10, wherein the modeling environment is operable to:
store code in the file that is operable to cause one or more functions associated with the tessellated model to execute in the lightweight viewer.

13. A method (90) of establishing a tessellated model comprising:
generating (90B) one or more geometric objects that establish a tessellation of geometry stored in a computer-aided design (CAD) model, wherein the one or more geometric objects are operable to display the tessellation of the geometry in a viewing window of a user interface;
generating (90F) one or more annotation objects;
assigning (90E-1) information associated with the respective one or more geometric objects to the one or more annotation objects, wherein the one or more annotation objects are operable to depict the respective information as a graphical annotation in the viewing window;
extracting (90C) edges of the geometry in the CAD model as a set of curves that differ from the tessellation of the geometry;
generating (90D) one or more curve objects;
assigning (90D-1) the set of curves to the respective one or more curve objects;
linking (90I) the one or more annotation objects to one or more of the curve objects;
wherein the one or more curve objects are operable to selectively depict the respective edges of the geometry in the viewing window in response to selection of the respective annotation object; and
generate (90K) a tessellated model including the one or more geometric objects, the one or more annotation objects and the one or more curve objects.

14. The method as recited in claim 13, wherein the one or more curve objects are operable to visually enhance respective segments of the one or more geometric objects associated with the respective edges; or
wherein selection of the one or more annotation objects causes the viewing window to highlight a boundary of the respective one or more geometric objects, and the one or more geometric objects are operable to depict the boundary by a set of triangles established by the tessellation of the geometry.

15. The method as recited in claim 12, further comprising:
storing (90L) the tessellated model in at least one file that excludes the CAD model; and, optionally,
displaying (90M) the tessellated model in a lightweight viewer.
